# FASCICULE DE BREVET EUROPEEN

(11) **EP 1 617 939 B1**
(45) Date de publication et mention de la délivrance du brevet: **09.09.2009**
(21) Numéro de dépôt: 04742839.6
(22) Date de dépôt: 09.04.2004
(51) Int. Cl.: B01J 2/00, B22F 3/12, C30B 15/02, C30B 29/06

(54) **PROCEDE DE FABRICATION DE GRANULES SEMICONDUCTEURS**
VERFAHREN ZUR HERSTELLUNG VON HALBLEITERGRANULATEN
METHOD FOR THE PRODUCTION OF SEMICONDUCTOR GRANULES

(30) Priorité: 14.04.2003 FR 0304675
(43) Date de publication de la demande: 25.01.2006
(60) Demande divisionnaire: 09164449.2
(73) Titulaire: CENTRE NATIONAL DE LA RECHERCHE SCIENTIFIQUE, 75794 Paris Cedex 16 (FR); UNIVERSITE DE POITIERS, 86034 Poitiers Cedex (FR)
(72) Inventeur: STRABONI, Alain, 86180 Buxerolles (FR)
(74) Mandataire: de Beaumont, Michel
(86) Numéro de dépôt international: PCT/FR2004/050152
(87) Numéro de publication internationale: WO 2004/091767

(56) Documents cités:
- EP-A- 0 230 617
- WO-A-00/68999
- DE-A- 2 258 305
- DE-A- 19 859 288
- FR-A- 2 038 715
- FR-A- 2 479 276
- FR-A- 2 814 757
- US-A- 4 759 887
- CHATTERJEE S ET AL: "A miniature PTC thermistor based sensor element fabricated by tape casting technique" SENSORS AND ACTUATORS B, ELSEVIER SEQUOIA S.A., LAUSANNE, CH, vol. 60, no. 2-3, 23 novembre 1999 (1999-11-23), pages 155-160, XP004253072 ISSN: 0925-4005
- SELVAN R K ET AL: "Combustion synthesis of CuFe2O4" MATERIALS RESEARCH BULLETIN, ELSEVIER SCIENCE PUBLISHING, NEW YORK, US, vol. 38, no. 1, 1 janvier 2003 (2003-01-01), pages 41-54, XP004399542 ISSN: 0025-5408

## Description

La présente invention concerne le domaine des matériaux semiconducteurs, et en particulier mais non exclusivement les granules semiconducteurs utilisables pour alimenter un bain fondu destiné à la réalisation de lingots de matériau semiconducteur, comme le silicium.

De façon classique, les lingots de silicium mono ou polycristallin sont obtenus par croissance ou étirement à partir de bains de silicium fondu. Ces bains sont alimentés par des granules ou des morceaux de silicium de traille supérieure à 1 mm. En effet, si l'on alimente un bain de silicium avec des particules plus petites, ces particules s'incorporent très difficilement au bain fondu ce qui nuit à la bonne marche du processus.

Le document FR-A-2 814 757 (INVENSIL) décrit la fabrication de granules de silicium par envoi d'un jet de silicium liquide dans l'eau.

Le document DE 198 59 288A (BAYER) décrit la fabrication d'agglomérats de silicium par accroissement de particules de silicium à l'aide d'un rayonnement à micro-oncles.

Un procédé classique de fabrication de granules est le suivant. Dans un réacteur de dépôt chimique en phase vapeur (CVD), du gaz silane SiH₄ ou trichlorosilane SiHCl₃ est cracké, c'est-à-dire chauffé de façon à ce que sa molécule soit cassée. Du silicium solide est alors libéré et se dépose sous forme de poudres. Au début du processus, les poudres obtenues sont très fines, typiquement de l'ordre de quelques dizaines de nanomètres. Pour faire grossir les grains de ces poudres, on doit mettre en oeuvre des conditions particulières qui entraînent une complexification du procédé et des équipements. On utilise par exemple des machines de dépôt à lit fluidisé qui permettent le grossissement des grains de poudres jusqu'à un à deux millimètres.

Le procédé décrit ci-dessus est long et consomme beaucoup d'énergie. Le prix de revient des granules est élevé. En outre, ce procédé de fabrication laisse des résidus sous la forme de poudres très fines, nettement inférieures au millimètre, inexploitées à l'heure actuelle.

Un objet de la présente invention est de prévoir un procédé pour fabriquer des granules propres à alimenter un bain de fabrication de lingots de matériaux semiconducteurs, qui soit rapide, peu cher et consomme peu d'énergie.

Pour atteindre cet objet ainsi que d'autres, la présente invention prévoit un procédé tel que défini dans l'une quelconque des revendications.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1F illustrent la fabrication de granules selon la présente invention ;
les figures 2A et 2B illustrent un mode de réalisation d'un procédé selon la présente invention ;
la figure 3 représente un granule obtenu selon la présente invention ; et
la figure 4 illustre un autre mode de réalisation du procédé selon la présente invention.

Pour fabriquer des granules peu chers, en peu de temps et en consommant peu d'énergie, l'inventeur a eu l'idée de fritter ou de fondre des poudres semiconductrices.

Les poudres utilisées sont par exemple les poudres de taille nanométrique (10 à 500 nm) issues des réacteurs CVD.

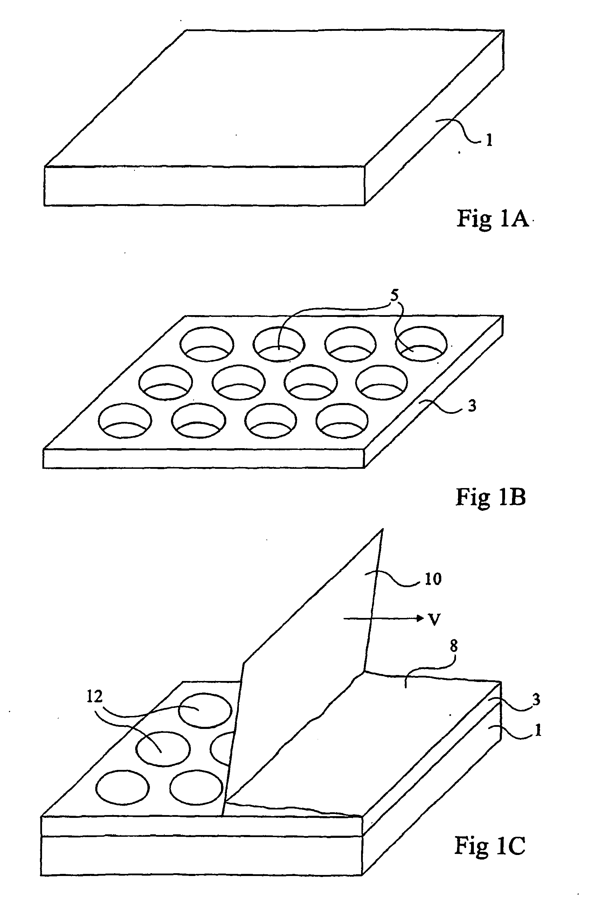

On va maintenant décrire la fabrication des granules selon la présente invention en relation avec les figures 1A à 1F.

La figure 1A représente un support 1 plan de forme parallélépipédique. Le support 1 est destiné à être une pièce de compression et il est réalisé par exemple par une lame de graphite, ou d'une autre céramique. Pour réaliser le support 1, on peut par exemple utiliser du nitrure de silicium Si₃N₄, du carbure de silicium SiC, du nitrure de bore BN, de l'alumine, de la zircone, de la magnésie etc.

Au-dessus du support 1 de la figure 1A, on place un moule 3 représenté à la figure 1B. Le moule 3 est une plaque percée d'ouvertures 5. Les ouvertures 5 représentées en figure 1B ont une section circulaire. Typiquement, l'épaisseur du moule 3 est de l'ordre de un à quelques millimètres, et le diamètre des ouvertures 5 est par exemple compris entre 1 et 5 millimètres.

Ensuite, comme cela est représenté en figure 1C, l'ensemble formé par la superposition du support 1 et du moule 3 est recouvert de poudres de matériau semiconducteur 8. Les poudres semiconductrices 8 sont raclées par un élément racleur 10 dans le sens de la flèche V. L'élément 10 racle les poudres 8 et, après son passage, les ouvertures 5 du moule 3 sont remplies de poudres 12.

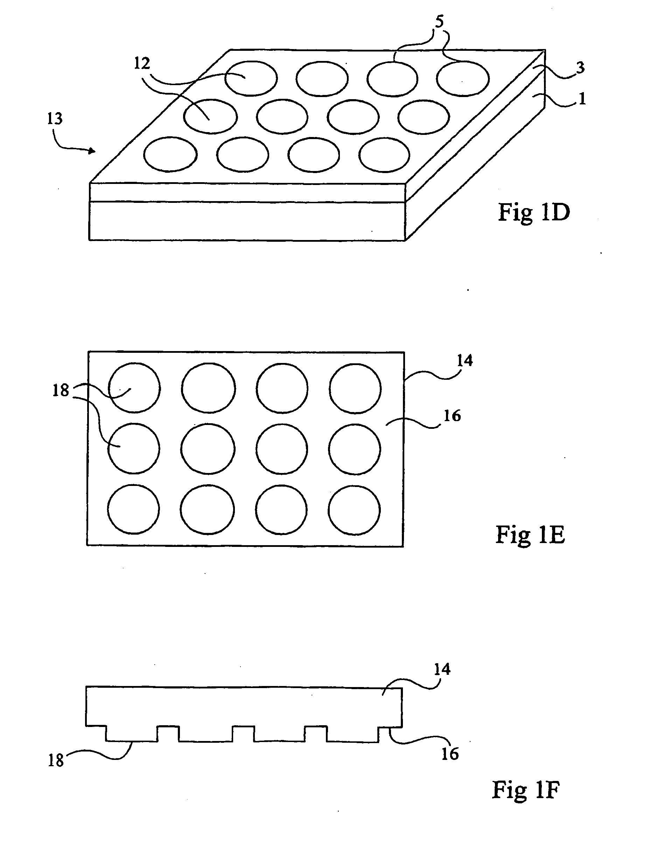

On obtient, comme cela est représenté à la figure 1D, un ensemble 13 formé par le support 1 surmonté du moule 3, dont les ouvertures 5 sont remplies de poudres 12.

Au-dessus de l'ensemble 13, on place un plateau 14. Le plateau 14 peut être réalisé dans le même matériau que le support 1. Le plateau 14 présente, sur sa face inférieure représentée en figure 1E, une surface plane 16 de laquelle dépassent des protubérances 18 complémentaires des ouvertures 5 et moins hautes que ces ouvertures sont profondes.

La figure 1F représente le plateau 14 en coupe. Les protubérances 18 sont constituées par des éléments de cylindre de diamètre légèrement inférieur aux ouvertures 5. La position des protubérances 18 est la même que celle des ouvertures 5. Le plateau 14 est placé au-dessus de l'ensemble 13 de la figure 1D, de façon à ce que les protubérances 18 soient au-dessus des ouvertures 5, remplies de poudre de silicium 12.

On va maintenant décrire plusieurs modes de réalisation du procédé selon la présente invention pour fabriquer les granules.

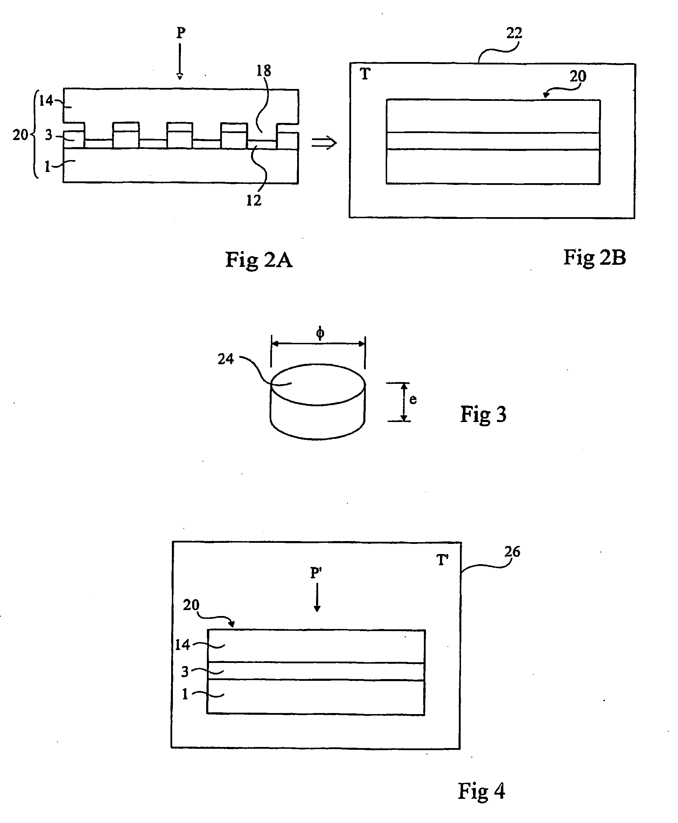

La figure 2A représente en coupe un ensemble 20 constitué par le support 1, le moule 3 comportant les poudres de silicium, et le plateau 14. Une pression P est exercée entre les éléments 1 et 14. La pression P assure un compactage des poudres de silicium 12 contenues dans le moule 3, les protubérances 18 du plateau 14 pénétrant dans les ouvertures 5 du moule 3 et comprimant les poudres. Du fait du compactage, un processus de consolidation commence à se produire. Après compaction, comme cela est illustré en figure 2B, l'ensemble 20 est placé dans un four de recuit 22 où il est soumis à un traitement thermique à une température T. Par souci de simplicité, l'ensemble 20 est représenté de façon simplifiée en figure 2A, les protubérances 18 en particulier n'ayant pas été représentées. Un frittage a lieu dans le four 22 et les granules obtenus ont une excellente tenue mécanique.

La pression exercée dans l'étape de compression de la figure 2A peut varier dans une grande plage de valeurs, par exemple allant de 100 bars (10 mégapascals) à 10 000 bars (1 gigapascal). La température utilisée lors du traitement thermique de la figure 2B peut également varier dans une grande plage de valeurs. Par exemple, elle peut être de l'ordre de 1000°C.

De façon générale, plus la pression lors de l'étape de compression est importante, plus le recuit thermique peut être faible. Les granules ayant subi un traitement thermique à température élevée présentent une tenue mécanique meilleure.

On notera cependant que, la consolidation des poudres commençant à température ambiante, on peut envisager d'obtenir des granules par simple compaction à froid, c'est-à-dire à température ambiante, des poudres. On notera cependant que des granules non recuits sont fragiles et, à moins de les manipuler avec soin, ils risquent de s'effriter pendant leur transport au bain fondu.

On peut aussi envisager de ne pas compacter les poudres, et de porter l'ensemble 20 dans le four 22 à une température pouvant aller jusqu'à la température de fusion du matériau, 1410°C dans le cas du silicium. Dans ce cas, le plateau supérieur 14 est superflu. A priori, si le support 1 est en graphite, on évitera que le silicium fonde car le granule obtenu peut rester soudé au support 1.

La figure 3 représente un granule 24 obtenu par le procédé de la figure 2. Le granule 24 se présente sous la forme d'une pastille cylindrique d'épaisseur e inférieure à l'épaisseur du moule 3 et de diamètre sensiblement égal au diamètre des ouvertures 5 du moule 3. Pour donner un ordre d'idée, l'épaisseur e est de 1 à 3 millimètres et le diamètre Φ de l'ordre de 1 à 5 mm.

S'ils n'ont pas été recuits jusqu'à la fusion, les granules obtenus par le procédé de la figure 2 présentent une porosité assez importante, en général située entre 20 et 40 %. Il s'agit d'une porosité interconnectée, dite aussi porosité ouverte, c'est-à-dire que des canaux de porosité sont présents dans tout le granule et débouchent sur l'extérieur. Cette caractéristique peut être mise à profit de plusieurs manières, par exemple dans un but de purification ou de dopage.

En effet, si ces granules comportent des impuretés, par exemple du fait d'une pollution des poudres de silicium utilisées, les granules peuvent être soumis à un traitement thermique ultérieur pour faire migrer les impuretés vers l'extérieur des granules par l'intermédiaire des canaux de porosité.

Aussi, on peut faire circuler un gaz dopant lors d'un recuit ultérieur pour doper les granules. Le gaz se répandant de manière uniforme dans la masse du granule du fait de sa porosité interconnectée, un dopage homogène du granule est obtenu dans sa masse. On peut aussi obtenir des granules dopés en réalisant les granules à partir de poudres semiconductrices déjà dopées. On notera que les granules classiques produits dans les réacteurs CVD ne sont pas dopés et que le fait de pouvoir doper facilement les granules constitue un avantage supplémentaire de la présente invention.

La figure 4 représente une variante du procédé pour fabriquer des granules selon la présente invention. L'ensemble 20, représenté là aussi de façon simplifiée et constitué, rappelons le, du support 1, du moule 3 garni de poudres de silicium et du plateau 14, est placé dans une enceinte 26, dans laquelle les poudres de silicium sont soumises à une étape de compaction à chaud. Pour ce faire, une pression P' est exercée entre les éléments 1 et 14, tandis que l'ensemble est soumis à un traitement thermique de température T'. La pression P' peut être exercée pendant toute la durée du traitement thermique ou seulement pendant une partie de ce traitement.

Le procédé de la figure 4 est remarquable en ce que l'obtention des granules est presque immédiate. Par exemple, si l'on exerce la pression P' pendant environ 1 seconde et l'on chauffe à 1200°C pendant environ 1 minute, on obtient rapidement et de manière très économique des granules très solides mécaniquement. Par ailleurs, la pression P' peut être beaucoup plus faible que la pression P du procédé de la figure 2 pour obtenir des granules présentant sensiblement la même résistance mécanique. Par exemple, une pression P' inférieure à 30 MPa (300 bars) convient parfaitement. La température T' peut être de l'ordre de grandeur de la température T, par exemple comprise entre 800°C et la température de fusion du silicium (1410°C).

Les granules obtenus par le procédé de la figure 4 sont de même type que les granules obtenus par le procédé de la figure 2. Cependant, leur porosité est en général plus faible, par exemple 10 % ou moins. Si l'on veut conserver les avantages liés à une porosité élevée des granules, il faudra veiller à ce que celle-ci ne soit pas trop faible.

La taille des granules obtenus n'est pas critique. Il suffit que les granules soient assez gros pour pouvoir alimenter les bains fondus où sont produits les lingots de silicium. Dans la pratique, il suffit que leur taille soit millimétrique, par exemple de l'ordre de un à quelques millimètres. Si besoin est, des granules de plus grande dimension peuvent être obtenus par simple augmentation de la taille des ouvertures 5 du moule 3.

La forme des granules obtenus n'est pas critique. Bien que l'on ait représenté des granules cylindriques, les granules pourront être en forme de cubes, de parallélépipèdes rectangles ou autre, selon la forme des ouvertures 5 du moule 3. Les granules peuvent être par exemple allongés, en forme de barres, de fils, etc.

Les poudres utilisées peuvent être des poudres nanométriques, par exemple d'un diamètre de l'ordre de 20 nm, des poudres micrométriques, des poudres millimétriques ou un mélange de poudres de diverses granulométries.

L'atmosphère de réaction dans le four 22 ou l'enceinte 26 peut être le vide ou une pression contrôlée d'un gaz inerte ou non, par exemple d'argon, d'azote ou de chlore. On peut aussi utiliser un gaz qui contient une pression de vapeur d'un élément autre que le silicium, par exemple d'un autre semiconducteur, ou d'un dopant du silicium comme le bore, le phosphore ou l'arsenic.

Bien entendu, la présente invention est susceptible de diverses variantes et modifications qui apparaîtront à l'homme de l'art.

En particulier, on notera que les divers éléments décrits en relation avec les figures 1A à 1F ne sont que des exemples seulement et peuvent subir de nombreuses modifications.

Par exemple, le plateau 14 peut ne pas présenter de protubérances 18 si le matériau formant le moule 3 est assez souple et/ou déformable pour que les îlots de poudre qu'elle renferme puissent être comprimés de manière adéquate.

On peut aussi se passer du moule 3. Par exemple, des petits tas de poudre peuvent être placés de façon espacée sur un support. Un plateau est placé sur l'ensemble, qui subit le procédé des figures 2 ou 4. Les petits tas de poudre sont écrasés par la compression et, s'ils sont suffisamment éloignés les uns des autres, ils formeront des granules séparés.

On notera aussi qu'il est possible d'utiliser non pas un seul moule 3, mais plusieurs moules 3 superposés et séparés de façon adéquate. Par exemple, on peut faire un empilement constitué d'un support 1, d'un moule 3 rempli de poudres de silicium, d'un plateau 14, suivi d'un autre moule 3 rempli de poudres de silicium, d'un autre plateau 14 etc. pour réaliser de nombreux granules en même temps.

Les poudres utilisées pour former les granules peuvent être constituées d'un mélange de poudres de granulométries adaptées à une compacité souhaitée.

## Revendications

1. Procédé de fabrication de granules en silicium propres à alimenter un bain fondu de fabrication de matériau semiconducteur, **caractérisé en ce qu'**il comporte une étape de compression à chaud ou une étape de compaction suivie d'une étape de traitement thermique de poudres de silicium de taille nanométrique provenant d'un réacteur de dépôt chimique en phase vapeur.

2. Procédé selon la revendication 1, dans lequel les granules ont une taille supérieure à 1 mm.

3. Procédé selon l'une des revendications 1 et 2, dans lequel, dans l'étape de compaction suivie d'une étape de traitement thermique, la pression est comprise entre 10 MPa et 1 GPa et la température est supérieure à 800°C.

4. Procédé selon l'une des revendications 1 à 2, dans lequel, lors de l'étape de compression à chaud, la pression est inférieure à 100 MPa et la température est supérieure à 800°C.

5. Procédé selon l'une des revendications 1 à 4, dans lequel la compression ou la compaction des poudres est réalisée à l'aide d'un moule (1, 3, 14).

6. Procédé selon la revendication 5, dans lequel le moule (1, 3, 14) comporte un support (1), une plaque (3) percée d'ouvertures (5) et un plateau (14) plan ou portant des protubérances (18).

7. Procédé selon une des revendications 5 et 6, dans lequel le moule est en graphite.

8. Procédé selon l'une des revendications 1 à 7, dans lequel les poudres sont des poudres semiconductrices dopées.

9. Procédé selon l'une des revendications 1 à 7, comportant une étape de recuit ou de dopage des granules.

## Claims

1. A method for manufacturing silicon semiconductor granules intended to feed a semiconductor material manufacturing melt, **characterized in that** it comprises a hot pressing step or a compaction step followed by a thermal processing step of silicon powders of nanometric size issued from a chemical vapor deposition reactor.

2. The method of claim 1, wherein the granules have a size greater than 1 mm.

3. The method of one of claims 1 and 2, wherein, in the compaction step followed with a thermal processing step, the pressure ranges between 10 MPa and 1 GPa and the temperature is greater than 800°C.

4. The method of one of claims 1 and 2, wherein, in the hot pressing step, the pressure is lower than 100 MPa and the temperature is greater than 800°C.

5. The method of one of claims 1 to 4, wherein the compression or the compaction of the powders is performed using in a mould (1, 3, 14).

6. The method of claim 5, wherein the mould (1, 3, 14) comprises a support (1), a plate (3) pierced with openings (5) and a plate (14) planar or exhibiting protrusions (18).

7. The method of one of claims 5 and 6, wherein the mould is of graphite.

8. The method of one of claims 1 to 7, wherein the powders are doped semiconductor powders.

9. The method of one of claims 1 to 7, comprising a step of anneal or doping of the granules.

## Patentansprüche

1. Verfahren zum Herstellen von Silizium-Halbleitergranulat zum Speisen einer Halbleitermaterial-Herstellungsschmelze, **dadurch gekennzeichnet, dass** es die folgenden Schritte aufweist:
einen Heißpressschritt oder
einen Verdichtungsschritt, gefolgt von einem thermischen Verarbeitungsschritt von Silizium Pulver in Nanometergröße, welches von einem chemischen Dampfabscheidereaktor ausgegeben wird.

2. Verfahren nach Anspruch 1, wobei das Granulat eine Größe, größer als 1 mm aufweist.

3. Verfahren nach einem der Ansprüche 1 und 2, wobei im Verdichtungsschritt, gefolgt durch einen thermischen Verarbeitungsschritt, der Druckbereich zwischen 10 MPa und 1 GPa liegt und die Temperatur höher als 800°C ist.

4. Verfahren nach einem der Ansprüche 1 und 2, wobei im Heißpressschritt, der Druck niedriger als 100 MPa und die Temperatur höher als 800°C ist.

5. Verfahren nach einem der Ansprüche 1 bis 4, wobei das Komprimieren oder Verdichten des Pulvers unter Benutzung einer Form (1, 3, 14) ausgeführt ist.

6. Verfahren nach Anspruch 5, wobei die Form (1, 3, 14) eine Träger (1), eine Platte (3), welche mit Öffnungen (5) versehen ist und eine Platte (14), die eben ist oder Vorsprünge (18) aufweist.

7. Verfahren nach einem der Ansprüche 5 und 6, wobei die Form aus Graphit ist.

8. Verfahren nach einem der Ansprüche 1 bis 7, wobei das Pulver dotiertes Halbleiterpulver ist.

9. Verfahren nach einem der Ansprüche 1 bis 7, das einen Schritt des Temperns oder Dotierens des Granulats aufweist.
